Europäisches Patentamt

(19) European Patent Office

Office européen des brevets

(11) Numéro de publication: **0 097 752 B1**

(12) **FASCICULE DE BREVET EUROPEEN**

(45) Date de publication du fascicule du brevet:
02.05.85

(21) Numéro de dépôt: 82420088.5

(22) Date de dépôt: 30.06.82

(51) Int. Cl.⁴: **G 01 R 1/067**

(54) **Pointe de touche pour mesures électriques et analogues.**

(43) Date de publication de la demande:
11.01.84 Bulletin 84/2

(45) Mention de la délivrance du brevet:
02.05.85 Bulletin 85/18

(84) Etats contractants désignés:
**BE CH DE GB IT LI SE**

(56) Documents cités:
**DE - C - 829 325**
**DE - C - 837 728**
**FR - A - 2 408 146**
**US - A - 3 201 746**
**US - A - 4 030 030**

(73) Titulaire: **"LUCIEN FERRAZ & Cie" Société Anonyme, 28, Rue Saint Philippe, F-69003 Lyon (FR)**

(72) Inventeur: **Chambon, Michel, 14 Rue Victor Mirabeau, F-69680 Chassieu (FR)**

(74) Mandataire: **Monnier, Joseph et al, Cabinet Monnier 142-150, Cours Lafayette, F-69003 Lyon (FR)**

## Description

La présente invention se réfère aux pointes de touche qu'on utilise en électrotechnique pour établir un contact momentané entre un conducteur fixé à cette pointe et un organe normalement sous tension, notamment pour vérifier l'existence de cette tension et en déterminer les caractéristiques (valeur, fréquence, phase, etc.).

De telles pointes comportent une pointe métallique proprement dite et un manche isolant à travers lequel cette pointe est reliée au conducteur. Dans le cas de courants faibles, la pointe métallique peut être directement fixée à une âme conductrice prévue à l'intérieur du manche et à l'extrémité opposée de laquelle le conducteur est raccordé, par exemple par un système de borne perforée dans le sens axial, avec vis de serrage transversale. La manœuvre du dispositif ne comporte alors aucun risque et il importe peu que l'opérateur puisse toucher accidentellement la pointe métallique ou la borne de retenue du conducteur. Mais dès que les tensions susceptibles d'être mises en jeu et/ou les intensités susceptibles d'apparaître dépassent une certaine limite, les pointes de touche ainsi établies deviennent dangereuses et il faut donc leur associer des agencements propres à assurer la sécurité d'utilisation.

C'est ainsi qu'on a proposé, cf., par exemple, le document FR-A No 0408146, des dispositifs dans lesquels la pointe métallique est portée par un poussoir isolant monté à coulissement dans un corps creux, lui-même établi en matière isolante et qui est normalement maintenu par un système de ressort et de butée à une position de repos pour laquelle il recouvre totalement la pointe. Quand ce corps est appliqué contre une structure métallique, le poussoir peut coulisser à l'encontre du ressort afin d'amener la pointe au contact de ladite structure. En outre, ce poussoir est avantageusement muni d'une cartouche à fusibles qui protège le dispositif et l'appareillage qui lui est associé à l'encontre des courts-circuits.

Il y a toutefois lieu de noter que, lorsque la cartouche a fonctionné, le dispositif devient complètement hors d'état de servir; de plus, il risque de se révéler dangereux puisqu'il peut indiquer à tort à un utilisateur non informé ou peu consciencieux que tel ou tel conducteur ou telle autre pièce n'est pas sous tension alors qu'au contraire il ou elle s'y trouve.

C'est à cet inconvénient qu'entend principalement remédier la présente invention, laquelle consiste à prévoir la cartouche à fusibles sous forme amovible et remplaçable ainsi qu'à doter la pointe de touche d'un encliquetage qui, aussi longtemps qu'une cartouche fondue n'a pas été correctement remplacée par une nouvelle en état de fonctionnement, verrouille le corps sur le poussoir à la position de repos pour laquelle la pointe métallique est totalement recouverte par ledit corps.

Plus précisément, l'invention propose une pointe de touche pour vérifications et essais électriques, du genre comprenant un poussoir isolant portant en bout une pointe métallique, un corps isolant creux avec extrémité à diamètre réduit monté à coulissement sur ce poussoir et normalement maintenu par un système de ressort et de butée à une position de repos pour laquelle il recouvre totalement la pointe, mais en permettant de la dégager moyennant déformation du ressort, une cartouche à fusibles disposée à l'intérieur du poussoir et insérée électriquement entre la pointe et une borne de liaison prévue à l'extrémité du poussoir opposée au corps, caractérisée en ce que la cartouche est amovible et remplaçable et en ce qu'il est prévu, sur le poussoir et à l'intérieur du corps, des moyens d'encliquetage pour verrouiller le corps à sa position de repos par rapport au poussoir lorsque la borne et la pointe métallique ne sont pas reliées l'une à l'autre par une cartouche.

Le dessin annexé, donné à titre d'exemple, permettra de mieux comprendre l'invention, les caractéristiques qu'elle présente et les avantages qu'elle est susceptible de procurer:

la fig. 1 est une coupe longitudinale générale d'une pointe de touche suivant l'invention, les pièces étant représentées à la position normale de repos;

la fig. 2 est une coupe transversale suivant II-II (fig. 1);

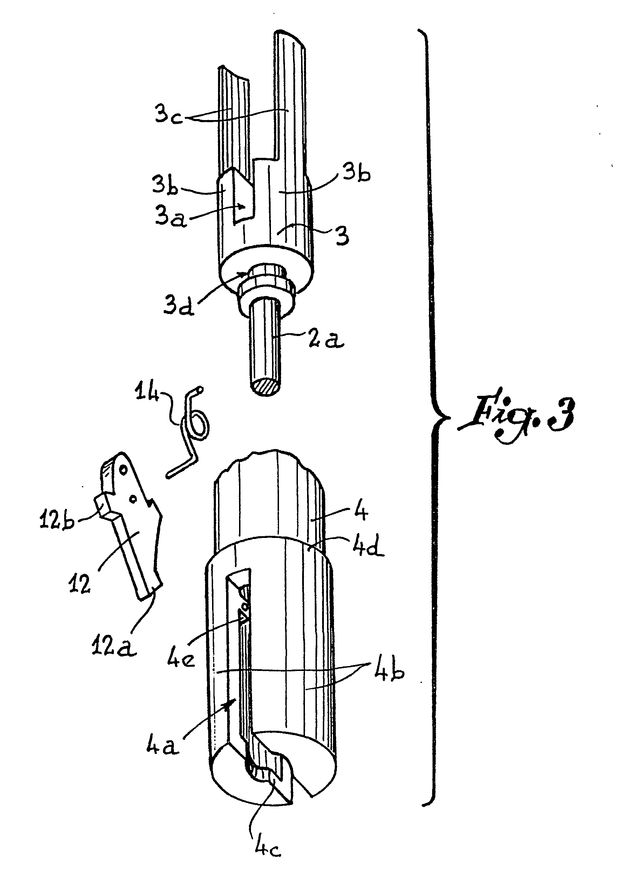

la fig. 3 est une vue en perspective éclatée montrant le noyau solidaire de la tige porte-pointe, l'extrémité avant fendue du poussoir, le cliquet et son ressort;

la fig. 4 est une coupe longitudinale partielle montrant la pointe de touche bloquée à la suite du fonctionnement de la cartouche à fusibles qu'elle renferme;

la fig. 5 est une vue semblable à celle de la fig. 4, mais dans laquelle le blocage résulte de l'absence de cartouche à fusibles;

la fig. 6 est une coupe longitudinale partielle à plus petite échelle que les vues précédentes, correspondant à une variante équipée d'un indicateur lumineux propre à signaler le fonctionnement de la cartouche.

La pointe de touche représentée comprend un corps creux ou tête isolante 1 constituée par une partie cylindrique principale 1a qu'une partie conique 1b relie à une extrémité cylindrique 1c à petit diamètre à l'intérieur de laquelle est logée au repos la pointe métallique 2. Cette dernière est solidaire d'une tige axiale 2a dont l'extrémité arrière est vissée dans un noyau métallique 3. Le noyau 3, prévu à profil extérieur cylindrique, est entaillé à partir de l'arrière (donc à l'opposé de la pointe 2) d'une fente transversale 3a qui y définit deux branches 3b, lesquelles se prolongent par deux lames élastiques minces 3c à section transversale en forme d'arc de cercle.

Le noyau 3 est retenu à l'intérieur d'un poussoir tubulaire isolant 4 qui se prolonge vers l'arrière bien au-delà de la tête 1 dans laquelle il est monté à coulissement. Ce poussoir est fendu transversalement sur une partie de sa longueur, comme indiqué en 4a, à partir de son extrémité avant dans laquelle est logé le noyau 3 et les deux branches 4b ainsi déterminées se terminent par un rebord 4c découpé intérieurement en arc de cercle pour venir s'engager dans une gorge circulaire 3d prévue dans une zone à diamètre réduit de la partie avant non fendue du noyau 3. On comprend que, si la matière constitutive du poussoir 4 est convenablement choisie, les deux branches définies par la fente 4a peuvent s'ouvrir élastiquement pour permettre la mise en place des rebords 4c autour de la gorge 3d. En variante, d'ailleurs, le poussoir 4 pourrait être fait en deux pièces à joint longitudinal qu'on engagerait sur le noyau 3 et qu'on souderait ou collerait l'une à l'autre.

Le poussoir 4 est repoussé vers l'arrière par un ressort de rappel 5 disposé autour de la tige 2a et qui prend appui contre un épaulement intérieur 1d prévu vers la jonction des parties 1b et 1c de la tête 1, de manière qu'au repos la pointe métallique 2 se trouve nettement effacée à l'intérieur de la partie 1c précitée. Pour définir positivement cette position, la partie arrière du poussoir 4 est prévue à un diamètre légèrement inférieur à celui de la partie avant de manière à déterminer un épaulement circulaire 4d qui vient former butée contre une nervure intérieure 1e réalisée à l'extrémité arrière de la tête 1. Afin de permettre le montage de la tête sur le poussoir, on peut notamment établir la première sous la forme de deux moitiés à joint longitudinal, qu'on engage sur le poussoir et qu'on soude ou colle ensuite l'une à l'autre. On pourrait également réaliser la nervure sur une couronne qu'on viendrait visser au bout de la tête.

L'extrémité arrière du poussoir 4 est filetée intérieurement pour recevoir par vissage un bouton tubulaire isolant 6 dont l'extrémité avant est solidaire par moulage ou autrement d'une pièce métallique cylindrique ou borne 7, de diamètre un peu moindre, percée à partir de l'arrière d'un alésage axial borgne 7a dans lequel débouche une perforation transversale 7b filetée pour recevoir une vis de serrage 8. Le conducteur 9 associé à la pointe de touche traverse le bouton 6, et son extrémité dénudée est serrée par la vis 8 à l'intérieur de l'alésage 7a.

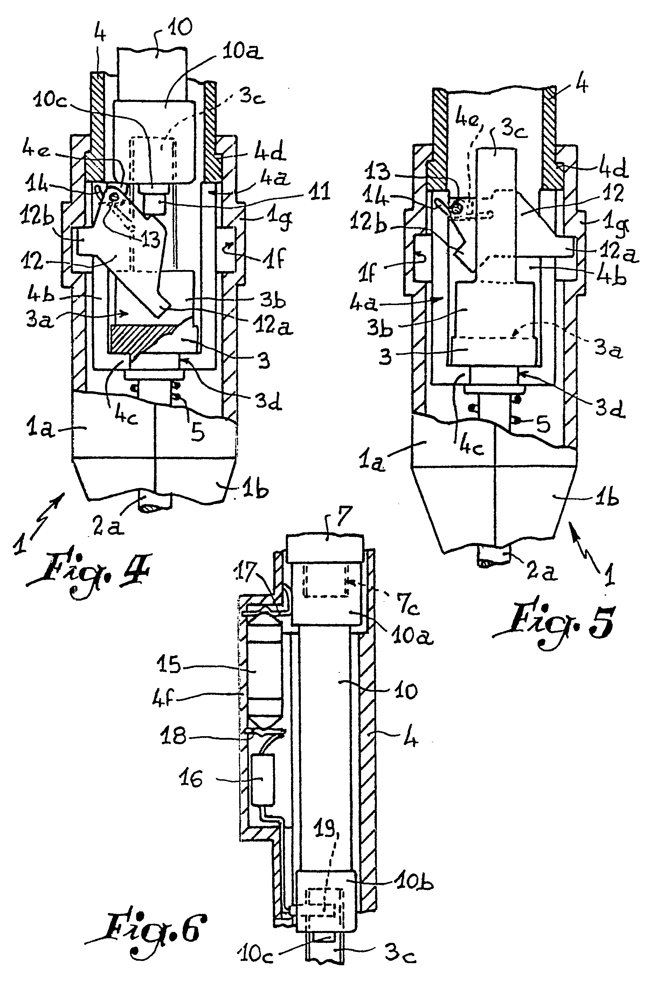

L'extrémité avant de la pièce ou borne 7 comporte un prolongement axial 7c sur lequel vient s'engager la tête arrière creuse 10a d'une cartouche à fusibles 10 disposée à l'intérieur du poussoir 4. L'autre tête ou tête avant 10b, de diamètre nettement inférieur à celui de la première, est équipée d'un percuteur axial 11 (voir fig. 4); elle s'engage entre les lames 3c qui s'appliquent élastiquement contre elles.

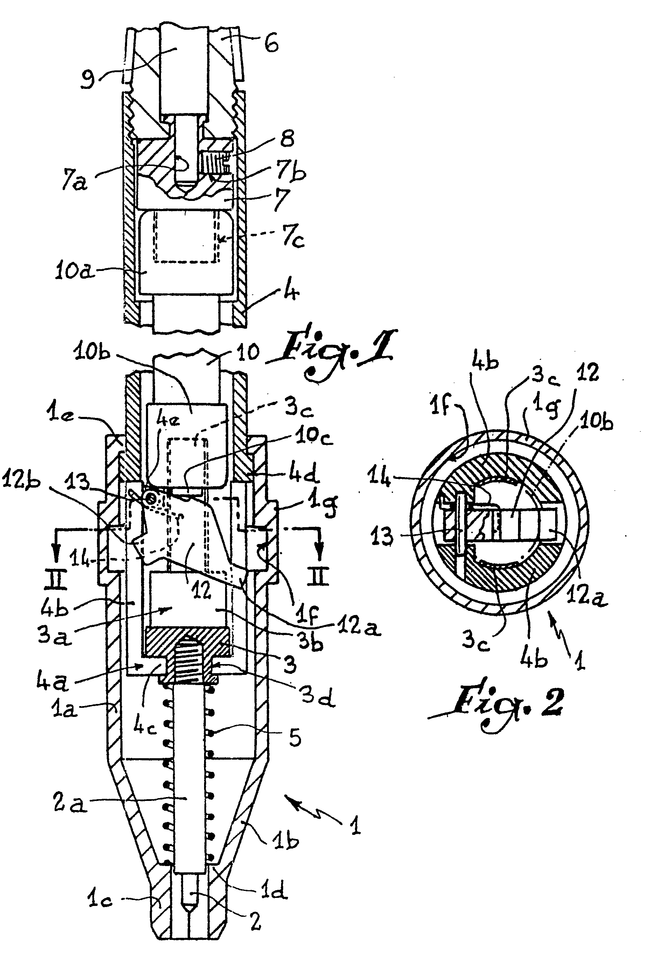

Dans la partie avant fendue du poussoir 4 et en avant de la tête 10 de la cartouche 10 est disposé un cliquet de verrouillage 12 monté sur un axe transversal 13 fortement déporté par rapport à l'axe général de l'ensemble de la pointe de touche. Ce cliquet est de forme plate, de façon à pouvoir s'engager dans la fente 3a du noyau 3. Son axe 13 est monté dans des bossages 4e prévus à l'intérieur du poussoir et il porte un ressort de torsion 14 qui le rappelle dans le sens sinistrorsum, ses extrémités convenablement recourbées étant engagées dans des perforations du cliquet et des branches 4b déterminées par la fente 4a du poussoir. Le cliquet 12 comporte, d'autre part, deux nez 12a et 12b susceptibles de venir s'engager dans une gorge intérieure 1f prévue dans une partie à plus fort diamètre 1g de la tête 1, suivant que ledit cliquet tourne dans un sens ou dans l'autre à partir d'une position de service normal, représentée en fig. 1 et 2, et cela quelles que soient les positions angulaires relatives de la tête 1 et du poussoir 4. A cette position de service, le cliquet 12 porte contre l'extrémité du percuteur 11, laquelle affleure alors le bossage central 10c de la tête 10b, de sorte qu'il n'est pas visible dans la vue de fig. 1 où la cartouche n'a pas été coupée.

Il est encore à noter que les bossages 4e sont établis pour former butée d'enfoncement de la cartouche 10 dans le poussoir 4 en limitant ainsi le vissage du bouton 6.

On comprend que, lorsque la pointe de touche se trouve à la position de repos représentée en fig. 1, les dents 12a et 12b du cliquet 12 sont effacées par rapport à la gorge 1f. Par conséquent, l'on peut repousser le poussoir 4 par le bouton 6 pour faire sortir la pointe métallique 2 et l'appliquer contre le conducteur, barre ou autre organe électrique à tester. Plus simplement, d'ailleurs, si l'on applique l'ensemble de l'appareil contre une surface, l'extrémité 1c du corps ou tête bute contre celle-ci et le ressort 5 se comprime jusqu'à ce que la pointe 2 soit venue la toucher. Dans l'un et l'autre cas, le câble 9 permet de prélever le courant électrique pour les mesures ou autres essais désirés, sans aucun risque d'électrocution pour l'opérateur.

Si les appareils électriques auxquels le câble 9 est relié comportent un court-circuit ou équivalent, le courant de surintensité traverse la cartouche 10 qui fond et protège le circuit. Son percuteur 11 vient faire basculer le cliquet 12 dans le sens dextrorsum en fig. 1, de sorte que, lorsqu'on revient à la position de repos, la dent 12b de celui-ci s'engage dans la gorge 1f (position de fig. 4) en bloquant le poussoir 4 par rapport au corps ou tête 1. La pointe de touche devient alors inutilisable jusqu'à ce que la cartouche ait été remplacée.

Lorsqu'on enlève la cartouche qui a fondu, le cliquet 12 est libéré et, sous l'effet de son ressort 14, il vient engager sa dent 12a dans la gorge 1f (position de fig. 5), de sorte que la pointe de touche reste bloquée jusqu'à ce qu'une nouvelle cartouche ait été mise en place. Il est à noter que, en raison du prolongement ou détrompeur 7c, il est impossible de monter une cartouche de type incorrect.

Dans la variante de fig. 6, on a prévu sur le poussoir 4 un renflement latéral 4f situé au droit de l'emplacement de la cartouche 10. Dans la cavité intérieure délimitée par ce renflement, on a disposé une ampoule à décharge 15 et une résistance 16 montées en série l'une à la suite de l'autre entre les têtes 10a et 10b de la cartouche 10. A cet effet, la paroi du renflement 4f est solidaire d'une première lame élastique 17 coudée à angle droit, l'une de ses branches recevant l'une des pointes de l'ampoule 15, tandis que l'autre forme contact latéral appliqué élastiquement contre la tête 10a. Une seconde lame 18 coopère avec l'extrémité opposée de l'ampoule 15 et l'une des extrémités de la résistance 16 lui est soudée. L'autre extrémité de celle-ci est soudée à une troisième lame élastique 19 agencée de manière à former contact appliqué contre la seconde tête 10b de la cartouche 10. On comprend que, lorsque la cartouche 10 fond, le courant électrique traverse la résistance 16 et l'ampoule 15 qui s'allume pour signaler l'incident à l'opérateur.

Bien entendu, la paroi du renflement 4f doit être prévue à tout le moins translucide, ou bien il faut lui rapporter une fenêtre transparente permettant d'apercevoir l'ampoule 15.

## Revendications

1. Pointe de touche pour vérifications et essais électriques, du genre comprenant un poussoir isolant (14) portant en bout une pointe métallique (2), un corps isolant creux (1) avec l'extrémité à diamètre réduit monté à coulissement sur ce poussoir et normalement maintenu par un système de ressort (5) et de butée à une position de repos pour laquelle il recouvre totalement la pointe, mais en permettant de la dégager moyennant déformation du ressort, une cartouche à fusibles (10) disposée à l'intérieur du poussoir et insérée électriquement entre la pointe et une borne de liaison (7) prévue à l'extrémité du poussoir opposée au corps, caractérisée en ce que la cartouche (10) est amovible et remplaçable et en ce qu'il est prévu, sur le poussoir (4) et à l'intérieur du corps (1), des moyens d'encliquetage (12, 1f) pour verrouiller le corps à sa position de repos par rapport au poussoir lorsque la borne (7) et la pointe métallique (2) ne sont pas reliées l'une à l'autre par une cartouche (10).

2. Pointe de touche suivant la revendication 1, caractérisée en ce que les moyens d'encliquetage comprennent un cliquet (12) articulé au poussoir (4) autour d'un axe transversal (13) déporté par rapport à l'axe général de la pointe, ce cliquet (12) comportant une dent (12a) propre à coopérer avec une gorge périphérique (1f) du corps (1), et étant rappelé élastiquement à une position pour laquelle la dent (12a) s'engage dans la gorge (1f), mais étant repoussé à la position effacée de la dent (12a) par la tête adjacente (10b) de la cartouche (10), de manière à permettre normalement au poussoir (4) de coulisser dans le corps (1), mais en le bloquant en cas d'absence de cartouche.

3. Pointe de touche suivant la revendication 1, caractérisée en ce que les moyens d'encliquetage comprennent un cliquet (12) comportant une dent (12b) susceptible de venir s'engager dans une gorge périphérique (1f) du corps (1), des moyens élastiques (14) sollicitant ce cliquet à tourner vers une position pour laquelle la dent (12b) est enfoncée par rapport à la gorge (1f), mais ledit cliquet pouvant être entraîné à l'encontre de ces moyens par le percuteur axial (11) de la cartouche (10), de manière que, lorsque celle-ci a fonctionné, ladite dent (12b) bloque le poussoir (4) à la position de repos à l'intérieur du corps (1).

4. Pointe de touche suivant l'ensemble des revendications 2 et 3, caractérisée en ce que le cliquet (12) comporte simultanément les deux dents (12a, 12b) de façon à assurer le blocage du poussoir (4) à l'intérieur du corps (1) dans tous les cas de défaillance et/ou d'absence de la cartouche.

5. Pointe de touche suivant l'une des revendications 2 ou 3, dans laquelle la pointe métallique est solidaire d'une tige fixée à un noyau en métal, lui-même fixé à l'extrémité avant du poussoir, caractérisée en ce que le noyau (3) se prolonge vers l'arrière sous forme de lames longitudinales élastiques (3c) qui viennent enserrer la liaison électrique de celle-ci avec la pointe métallique (2), tout en ménageant entre elles l'espace nécessaire pour les moyens d'encliquetage (12, 1f).

6. Pointe de touche suivant l'une des revendications qui précèdent, caractérisée en ce que la borne (7) comporte sur son extrémité avant un prolongement (7c) propre à venir s'engager à l'intérieur de la tête arrière (10a) de la cartouche (10) pour former détrompeur.

7. Pointe de touche suivant l'une des revendications 2 à 6, caractérisée en ce que l'axe (13) du cliquet (12) est porté par le poussoir (4) par l'intermédiaire de bossages (4e) qui constituent simultanément butées pour la seconde tête (10b) de la cartouche (10), la borne (7) étant fixée à l'arrière du poussoir (4) par l'intermédiaire d'un bouton terminal isolant (6) vissé dans celui-ci et qui repousse ainsi la cartouche (10) contre lesdits bossages (4e).

## Patentansprüche

1. Tastspitze für elektrische Prüfungen und Versuche mit einem isolierenden Drücker (4), der an einem Ende eine metallische Spitze (2) trägt, einem hohlen Isolierkörper (1) mit einem an seinem Ende kleineren Durchmesser, der schiebend auf diesem Drücker angebracht ist und normalerweise von einem Feder- (5) und Anschlagsystem in einer Ruhestellung gehalten wird, in der er die Spitze völlig verdeckt, jedoch ihre Freigabe über Federdeformation erlaubt, einer im Innern des Drückers angebrachten und elektrisch zwischen der Spitze und einer am anderen Ende bezüglich des Körpers des Drückers vorgesehenen Verbindungsklamme (7) befindlichen Sicherungspatrone (10), dadurch gekennzeichnet, dass die Patrone (10) herausnehmbar und auswechselbar ist und dass auf dem Drücker (4) und im Innern des Körpers in seiner Ruhelage bezüglich des Drückers vorgesehen sind, wenn die Klemme (7) und die metallische Spitze (2) nicht miteinander über eine Patrone (10) verbunden sind.

2. Tastspitze nach Anspruch 1, dadurch gekennzeichnet, dass die Einschnappmittel eine Klinke (12) umfassen, die am Drücker (4) um eine senkrecht zur allgemeinen Achse der Spitze drehbar angelenkt ist, der mit einer Nut (1f) am Umfang des Körpers (1) in Eingriff treten kann, und elastisch in eine Lage zurückgeholt wird, in der der Zahn (12a) mit der Nut (1f) in Eingriff tritt, jedoch vom danebenliegenden Kopf (10b) der Patrone (10) in die versenkte Lage zurückgestossen wird, derart, dass der Drücker (4) normalerweise im Körper (1) gleiten kann, aber im Fall der Abwesenheit einer Patrone blockiert wird.

3. Tastspitze nach Anspruch 1, dadurch gekennzeichnet, dass die Einschnappmittel eine Klinke (12) mit einem Zahn (12b) umfassen, der in Eingriff mit einer Nut (1f) am Umfang des Körpers (1) treten kann, mit elastischen Mitteln (14), die diese Klinke in eine Position drehen, in der der Zahn (12b) in der Nut (1f) versenkt ist, wobei aber die Klinke gegen diese Mittel durch den axialen Bolzen (11) der Patrone (10) derart mitgezogen werden kann, dass, wenn diese angesprochen hat, der Zahn (12b) den Drücker (4) in der Ruhestellung innerhalb des Körpers (1) blockiert.

4. Tastspitze nach den Ansprüchen 2 und 3, dadurch gekennzeichnet, dass die Klinke (12) gleichzeitig zwei Zähne (12a, 12b) trägt, um die Blockierung des Drückers (4) im Innern des Körpers (1) in allen Fällen von Fehlern oder/und Abwesenheit der Patrone (10) sicherzustellen.

5. Tastspitze nach einem der Ansprüche 2 oder 3, wobei die metallische Spitze fest verbunden ist mit einem an einem Kern aus Metall befestigten Stift, wobei dieser Kern wiederum am vor dem Drücker liegenden Ende befestigt ist, dadurch gekennzeichnet, dass der Kern (3) sich nach hinten in Form elastischer, longitudinaler Segmente (3c) verlängert, die das Vorderteil (10b) der Patrone (10) umschliessen, um die elektrische Verbindung dieser mit der metallischen Spitze (2) sicherzustellen, wobei der für die Einschnappmittel (12, 1f) notwendige Raum vorgesehen wird.

6. Tastspitze nach einem der vorhergehenden Ansprüche, dadurch gekennzeichnet, dass die Klemme (7) an ihrem Vorderende eine zum Eingriff in das Innere des Hinterteils (10a) der Patrone (10) geeignete Verlängerung (7c) aufweist.

7. Tastspitze nach einem der Ansprüche 2 bis 6, dadurch gekennzeichnet, dass die Achse (13) der Klinke (12) vom Drücker (4) über Ansätze (4e) getragen wird, die gleichzeitig Anschläge für das zweite Ende (10b) der Patrone (10) bilden, wobei die Klemme (7) hinten am Drücker (4) über einen isolierenden Anschlussknopf (6) befestigt ist, der in jenen hineingeschraubt ist und so die Patrone (10) gegen besagte Ansätze (4e) drückt.

**Claims**

1. Electrical circuit tester comprising an insulating push piece (4) having at one end a metallic point (2), a hollow insulating body (1) with an extremity of reduced diameter, mounted so as to slide on this push piece and normally held by a spring and stop system (5) in a position of rest in which the body covers the point completely, but allowing the point to be exposed on deformation of the spring, a cartridge of fuses (10) arranged interiorly of the push piece and inserted electrically between the point and an interconnecting terminal (7) provided on the end of the push piece opposite the body, characterized in that the cartridge (10) is detachable and replaceable, and in that ratchet means (12, 1f) are provided on the push piece (4) and interiorly of the body (1) to lock the body in its position of rest in relation to the push piece when the terminal (7) and the metallic point (2) are not connected with each other by the cartridge (10).

2. Circuit tester according to Claim 1, characterized in that the ratchet means comprise a ratchet (12) articulated to the push piece (4) about a transverse axis (13) offset in relation to the general axis of the point, this ratchet (12) comprising a cog (12a) capable of cooperating with a peripheral groove (1f) on the body (1), and being drawn back elastically to the position in which the cog (12a) engages the groove (1f), but being pushed back to the retracted position of the cog (12a) by the adjacent head (10b) of the cartridge (10), so as to normally allow the push piece (4) to slide in the body (1), but blocking the push piece in the absence of a cartridge.

3. Circuit tester according to Claim 1, characterized in that the ratchet means comprise a ratchet (12) including a cog (12b) which is able to engage a peripheral groove (1f) on the body (1), elastic means (14) urging this ratchet to turn toward a position in which the cog (12b) is driven in, in relation to the groove (1f), but with said ratchet capable of being drawn counter to these means by an axial hammer (11) of the cartridge (10), such that, when the latter has acted, said cog (12b) locks the push piece (4) in the position of rest on the interior of the body (1).

4. Circuit tester according to the whole of Claims 2 and 3, characterized in that the ratchet (12) comprises simultaneously the two cogs (12a-12b) so as to ensure the locking of the push piece (4) on the interior of the body (1) in all cases of failure and/or absence of the cartridge (10).

5. Circuit tester according to any one of the preceding Claims 2 or 3, in which the metallic point is integral with a stem fixed to a metal core which itself is fixed to the front extremity of the push piece, characterized in that the core (3) extends toward the rear in the form of longitudinal elastic plates (3c) which encompass the front head (10b) of the cartridge (10) to ensure the electric connection of the latter with the metallic point (2), whilst providing between them the necessary space for the ratchet means (12, 1f).

6. Circuit tester according to any one of the preceding claims, characterized in that the terminal (7) comprises on its front extremity an extension (7c) able to engage the interior of the rear head (10a) of the cartridge (10) to form security against error.

7. Circuit tester according to any one of Claims 2 to 6, characterized in that the axis (13) of the ratchet (12) is borne by the push piece (4) by means of bosses (4e) which also constitute stops for the second head (10b) of the cartridge (10), the terminal (7) being fixed to the rear of the push piece (4) by means of a terminal insulating button (6) screwed into the latter and which thus pushes back the cartridge (10) against said bosses (4e).

Fig. 1

Fig. 2

*Fig. 3*

Fig. 4

Fig. 5

Fig. 6